# EUROPEAN PATENT APPLICATION

(11) **EP 1 953 261 A2**
(43) Date of publication of application: **06.08.2008**
(21) Application number: 07020949.9
(22) Date of filing: 25.10.2007
(51) Int. Cl.: C23C 18/16, C25D 5/00, C23C 14/20

(54) **Method of fabricating plastic part having three-dimensional image and visual effect and structure thereof**

(30) Priority: 26.01.2007 CN 200710008124
(71) Applicant: U-Tech Media Corp., Tao Yuan Hsien (TW)
(72) Inventor: Huang, Chun-Chin, Tao-Yuan Hsien (TW); Kuan, Cheng-Chung, Tao-Yuan Hsien (TW); Cheng, Chieh-Jen, Tao-Yuan Hsien (TW); Liao, Chun-Lang, Tao-Yuan Hsien (TW); Wu, Jo-Wen, Tao-Yuan Hsien (TW); Lay, Jyh-Huei, Tao-Yuan Hsien (TW); Y.L. Jhu, Micheler, Tao-Yuan Hsien (TW); Chen, Tzung-Yan, Tao-Yuan Hsien (TW); Chen, Yuh-Far, Tao-Yuan Hsien (TW); Wang, Yuan-Hung, Tao-Yuan Hsien (TW)
(74) Representative: Schaeberle, Steffen

(57) **Abstract**

A method of fabricating a plastic part having a three-dimensional image and visual effect. A plastic part (30) having a three-dimensional graphical surface and a flat plane is formed. Subsequently, a thin film layer (32) is formed on the plastic part (30) to provide three-dimensional image and visual effect to the plastic part (30), where the three-dimensional graphical surface provides the three-dimensional image and the thin film layer (32) provides the visual effect.

## Description

The present invention relates to a method of fabricating a plastic part having a three-dimensional image and visual effect, a method of fabricating plastic thin film having three-dimensional image, and a plastic part having a three-dimensional image and visual effect, according to the pre-characterizing clauses of claims 1, 14, 15 and 17.

Plastic products are usually fabricated by means of injection molding. As plastic products are popularly used in recent years, varieties of plastic products are required for the market. However, the traditional plastic products have a disadvantage of plain texture. Therefore, it is still a challenge to fabricate plastic products having attractive texture and great quantities at the same time.

This in mind, the present invention aims at providing a method of fabricating a plastic part and the related plastic part that make the plastic part have a three-dimensional image and visual effect.

This is achieved by a method of fabricating a plastic part according to claim 1. The dependent claims pertain to corresponding further developments and improvements.

As will be seen more clearly from the detailed description below, the claimed plastic part includes a thin film layer that covers a three-dimensional graphical surface of the plastic part, and provides a visual effect.

In the following, the invention is further illustrated by way of example, taking reference to the accompanying drawings. Thereof:
Fig. 1 to Fig. 7 are schematic diagrams illustrating a method of forming a plastic part having a three-dimensional image and a visual effect according to a preferred embodiment of the present invention,
Fig. 8 is a schematic diagram illustrating the plastic part fabricated according to the method of the above-mentioned embodiment, and
Fig. 9 is a schematic diagram illustrating a method of fabricating a plastic part having a three-dimensional image and a visual effect according to another preferred embodiment of the present invention.

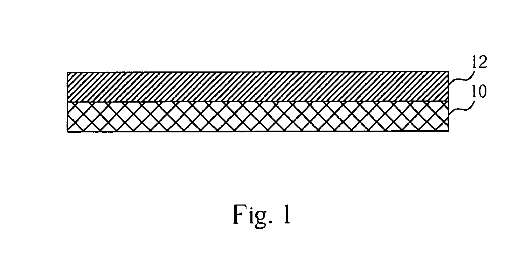

Please refer to Fig. 1 to Fig. 7. Fig. 1 to Fig. 7 are schematic diagrams illustrating a method of forming a plastic part having a three-dimensional image and a visual effect according to a preferred embodiment of the present invention. As shown in Fig.1, a substrate 10 is first provided, and a photoresist layer 12 is subsequently disposed onto the surface of the substrate 10. The substrate 10 can be a glass substrate or another insulating substrate, and the material of the photoresist layer 12 can be a wet photoresist or dry photoresist depending on the practical situation. In addition, the type of the photoresist layer 1 2 is also arbitrary. A positive photoresist or a negative photoresist can be selected according to the type or the pattern of the subsequently formed mask, or according to the number of times that the pattern will be transferred, so that the required pattern can be formed on the picture product.

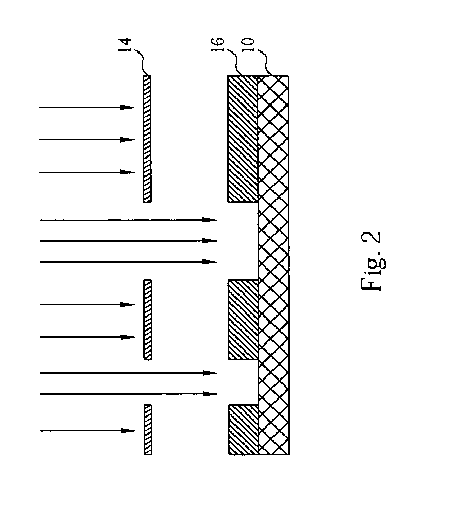

As shown in Fig. 2, a mask 14 is thereafter used to perform the exposing and developing process so as to turn the photoresist layer 12 into a photoresist pattern 16 corresponding to the pattern of the mask 14 on the surface of the substrate 10. If the photoresist layer 12 is a positive photoresist, the photoresist pattern 16 is identical to the pattern of the mask 14. If the photoresist layer 12 is a negative photoresist, the photoresist pattern 16 is complementary to the pattern of the mask 14.

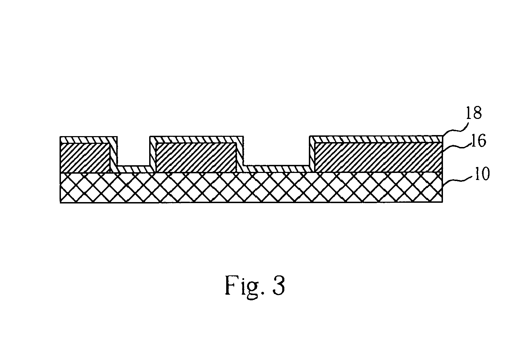

As shown in Fig. 3, a seed layer 18 is furthermore formed on the surface of the substrate 10 and the photoresist pattern 16. The seed layer 18 can be formed by means of evaporation, sputtering, or electroless plating. The thickness of the seed layer 18 can be on the order of nanometers, and is adjustable. Preferably, the material of the seed layer 18 can be nickel or silver, however, it can also be ITO, carbon film, or other suitable conductive materials.

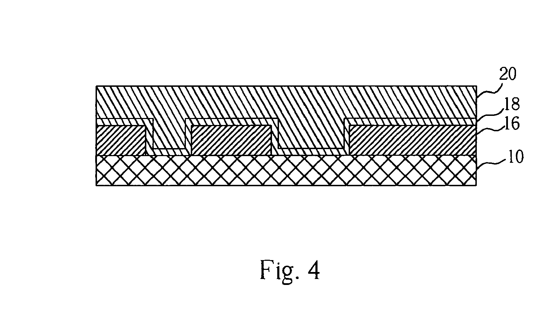

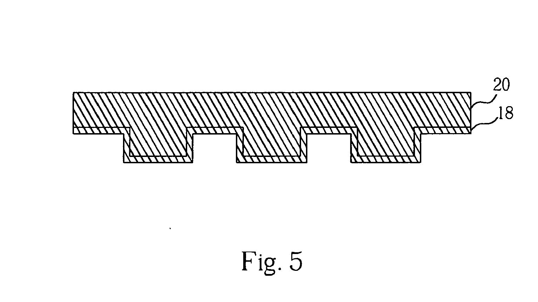

Afterward, as shown in Fig. 4, a metal layer 20 is formed on the surface of the seed layer 18 by electroforming, electroplating, or electroless plating. As shown in Fig. 5, a releasing process is next carried out to release the material layer 20 and the seed layer 18 from the surface of the substrate 10 and the photoresist pattern 16. In order to help the seed layer 18 be stripped from the substrate 10 and the photoresist pattern 16, another photoresist film (not shown in the drawing) can be further formed on the surface of the substrate 10 and the photoresist pattern 16 before the seed layer 18 is formed, which functions as a release layer. According to the above-mentioned processes, the method of this embodiment is to fabricate a stamper by means of a Lithographie Ga Vanoformung Abformung like (LIGA-like) process. However, the method of the present invention should not be limited thereto. The actual fabricating processes of the stamper can be adjusted according to various factors, such as product requirements and specification. In this embodiment, a stamper can include both the material layer 20 and the seed layer 18 that are released from the substrate 10. In other embodiment, the seeding layer 18 can be removed form the metal layer 20, and the metal layer 20 itself can function a stamper.

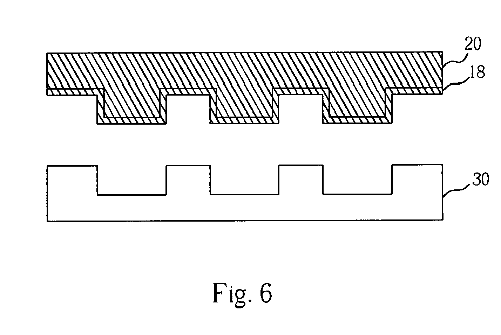

As shown in Fig. 6, a molding process is next performed to fabricate a plastic part 30 by utilizing the metal layer 20 and the seeding layer 18 as a stamper. Accordingly, the plastic part 30 can have a pattern that is complementary to the pattern of the stamper. Different plastic molding techniques can be adopted for the molding process according to the characteristics of different products. For instance, the plastic part 30 can be injected by injection molding process, or the pattern of the stamper can be transferred to the plastic part 30 by means of a hot-embossing process, a cold-embossing process, a casting process or a calendaring process, etc. By utilizing the above-mentioned molding technique, at least one three-dimensional graphical surface of the plastic part 30 can be fabricated, while the other side of the plastic part 30, which is opposite to the three-dimensional graphical surface, is a flat plane in this embodiment. The three-dimensional graphical surface of the plastic part 30 can include various patterns, such as protruding words having high resolution, protruding drawings having high resolution, geometric patterns having microstructures, or security patterns for anti-counterfeiting according to product requirements, where the patterns usually have two-dimensional visual effect for viewers. Furthermore, the plastic part 30 having the three-dimensional graphical surface can have dazzling visual effects while the plastic part 30 undergoes more processes. As a result, the plastic part can have better texture and extends its product application.

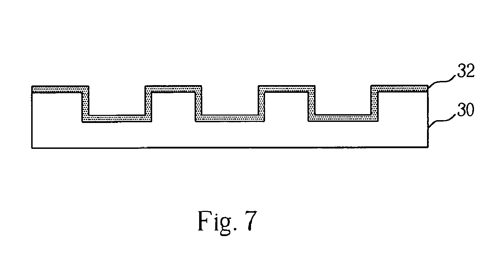

As shown in Fig. 7, a thin film layer 32 is next formed on the three-dimensional graphical surface of the plastic part 30 for the sake of enhancing the visual effect. In this embodiment, the thin film layer 32 is a metal thin film layer, and can be formed by a chemical vapor deposition process or a physical vapor deposition process, such as evaporation, sputtering, electroplating, or electroless plating. The thickness of the thin film layer 32 is approximately uniform, so the thin film layer 32 can rise and fall according to the outline of the three-dimensional graphical surface, and has an outline similar to the outline of the three-dimensional graphical surface. In other words, the thin film layer 32 is conformal to the plastic part 30. The thin film layer 32 is applied for providing special visual effect for the plastic part 30. For example, a metal material is selected for the thin film layer 32 in this embodiment, so the thin film layer 32 can provide a visual effect of metal-like texture. In addition to the three-dimensional image provided from the three-dimensional graphical surface of the plastic part 30 itself, the plastic part 30 having a three-dimensional image and a visual effect is manufactured according to the method of the present invention.

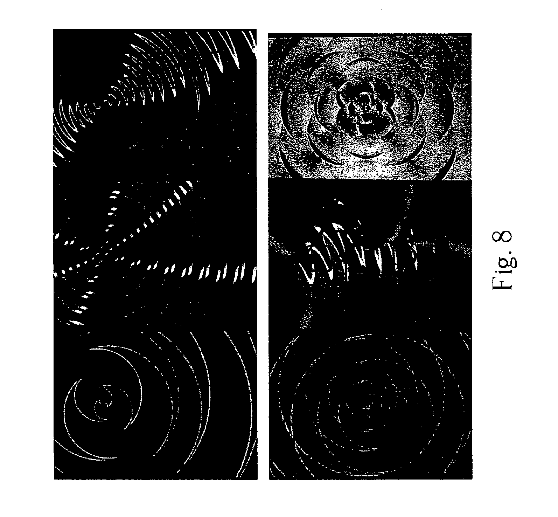

Please refer to Fig. 8, and also refer to Fig. 7 simultaneously. Figure 8 is a schematic diagram illustrating the plastic part fabricated according to the method of the above-mentioned embodiment. As shown in Fig. 8, the three-dimensional graphical surface of the plastic part 30 can provide the three-dimensional image, and the cooperation of the three-dimensional graphical surface and the thin film layer 32 positioned on the three-dimensional graphical surface can display special visual effects, such as brightness and dazzle. As a result, the application of plastic material can be extend to more products. The plastic material can be applied to nameplates of electronic products, such as nameplates on cellular phones, nameplates on digital cameras, or nameplates on digital video players, can be applied to keypads of electronic products, such as keypads on cellular phones, or keypads on personal digital assistants (PDA), and can be applied to optical mouse pads, various plaques, dial plates, and so on. It is noteworthy that the visual effect should not be limited to the metal-like texture shown in this preferred embodiment, and a variety of visual effects can be presented utilizing the present invention according to different materials of the thin film layer 32, and the different designed patterns of the three-dimensional graphical surface on the plastic part 30. For instance, if a microstructure pattern having concentric circle pattern (generally called a CD pattern) is included on the three-dimensional graphical surface of the plastic part 30, the later formed thin film layer 32 that covers the three-dimensional graphical surface can include a three-dimensional pattern having the same concentric circle pattern. In such a case, the thin film layer 32 of the plastic part 30 provides a dazzling effect. As for referring to other structures, the plastic part 30 can provide different visual effects or artistic effects, such as a brushed finishing effect or a ripple-like effect, as shown in Fig. 8.

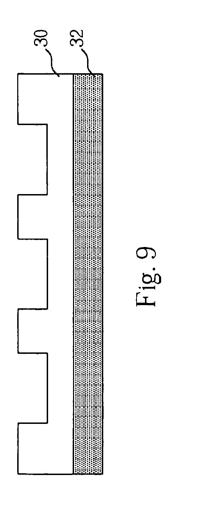

In addition, the position of the thin film layer 32 in the present invention should not be limited to the three-dimensional graphical surface of the plastic part 30, and the thin film layer 32 can be formed on the flat plane of the plastic part 30 according to product design. Please refer to Fig. 9, which is a schematic diagram illustrating a method of fabricating a plastic part having a three-dimensional image and a visual effect according to another preferred embodiment of the present invention, where the step shown in Fig. 9 is performed after the step shown in Fig. 6 of the above-mentioned embodiment. As shown in Fig. 9, different from the above-mentioned embodiment, the thin film layer 32 in this embodiment is disposed on the flat plane of the plastic part 30, rather than on the three-dimensional graphical surface. Moreover, the thin film layer 32 in this embodiment is a plastic thin film, such as a non-transparent plastic thin film, disposed on the flat plane of the plastic part 30 by means of attachment. Thus, the three-dimensional graphical surface of the plastic part 30 can express a three-dimensional image. Since the plastic thin film attached to the flat plane of the plastic part 30 is non-transparent, viewers watching from the three-dimensional graphical surface side of the plastic part 30 can observe a special visual effect because of catoptrics. In order to enhance the colorfulness of the plastic part 30, a print process or a plating process can be further carried out before the plastic part 30 and the thin film layer 32 are combined, so that an information layer 34 having words or drawings can be included on the surface of the plastic part 30 or on the surface of the thin film layer 32

In sum, the stamper fabricated by the LIGA-like process in the present invention is characterized by high resolution. In addition to the high resolution of the stamper, since the molding technology of the plastic parts has been developed well, plastic parts including a three-dimensional image, which has excellent fineness and attractive texture, can be quickly fabricated. Plastic parts, which are fabricated by the tradition molding technique or directly formed by machine, usually have plain texture or poor resolution. Furthermore, the plastic part can provide various visual effects, such as a metal-like texture, a brushed finishing effect, a dazzling effect, or a ripple-like effect, by means of the follow-up thin film process according to the product design. Therefore, the application of the plastic parts is effectively increased.

## Claims

1. A method of fabricating a plastic part (30) having a three-dimensional image and visual effect, **characterized by**:
fabricating a plastic part (30), the plastic part (30) having a three-dimensional graphical surface and a flat plane; and
forming a thin film layer (32) on the plastic part (30) so that the plastic part (30) has a three-dimensional image and a visual effect, the three-dimensional graphical surface of the plastic part (30) providing the three-dimensional image, and the thin film layer (32) providing the visual effect.

2. The method of claim 1, **characterized in that** the thin film layer (32) is disposed on the three-dimensional graphical surface of the plastic part (30).

3. The method of claim 2, **characterized in that** the thin film layer (32) is a thin metal film layer.

4. The method of claim 3, **characterized in that** the thin metal film the layer is fabricated by means of a physical vapor deposition process or a chemical vapor deposition process.

5. The method of claim 1, **characterized in that** the thin film layer (32) is disposed on the flat plane of the plastic part (30).

6. The method of claim 5, **characterized in that** the thin film layer (32) is a plastic thin film.

7. The method of claim 5, **characterized in that** the thin film layer (32) is formed on the flat plane of the plastic part (30) by means of attachment.

8. The method of claim 6, wherein the method is further **characterized by** a step of forming an information layer on a surface of the thin film layer (32) or on the flat plane of the plastic part (30), before the step of forming the thin film layer (32) of the plastic part (30).

9. The method of claim 8, **characterized in that** the information layer is formed by means of a printing process or a plating process.

10. The method of claim 1, **characterized in that** the step of fabricating the plastic part (30) comprises:
performing a Lithographie Ga Vanoformung Abformung like (LIGA-like) process to form a stamper, the stamper having a three-dimensional graphical surface that is complementary to the three-dimensional graphical surface of the plastic part (30); and
performing an injection molding process by utilizing the stamper, so as to fabricate the plastic part (30) having the three-dimensional graphical surface.

11. The method of claim 1, **characterized in that** the plastic part (30) is fabricated by means of a thermal compression process or a cold compression process.

12. The method of claim 1, **characterized in that** the plastic part (30) is fabricated by means of a casting process.

13. The method of claim 1, **characterized in that** the plastic part (30) is fabricated by means of a calendaring process.

14. A method of fabricating plastic thin film having three-dimensional image, **characterized by**:
performing a Lithographie Ga Vanoformung Abformung like (LIGA-like) process to form a stamper; and
performing an injection molding process by utilizing the stamper, so as to fabricate a plastic thin film having a three-dimensional graphical surface.

15. A plastic part (30) having a three-dimensional image and visual effect, **characterized by**:
a plastic part (30), the plastic part (30) having a three-dimensional graphical surface; and
a thin film layer (32), covering the three-dimensional graphical surface of the plastic part (30), thickness of the thin film layer (32) being approximately uniform, the thin film layer (32) rising and falling according to an outline of the three-dimensional graphical surface, the three-dimensional graphical surface providing the three-dimensional image, and the thin film layer (32) providing the visual effect.

16. The plastic part (30) of claim 15, **characterized in that** the thin film layer (32) is a thin metal film layer.

17. A plastic part (30) having three-dimensional image and visual effect, **characterized by**:
a plastic part (30), the plastic part (30) having a three-dimensional graphical surface and a flat plane; and
a thin film layer (32), covering the flat plane of plastic part (30);
wherein the three-dimensional graphical surface provides a three-dimensional image, and the thin film layer (32) provides a visual effect.
